(19) **Europäisches Patentamt / European Patent Office / Office européen des brevets**

(11) **EP 4 782 581 A1**

(12) **EUROPEAN PATENT APPLICATION**
published in accordance with Art. 153(4) EPC

(43) Date of publication:
**29.07.2026 Bulletin 2026/31**

(21) Application number: **24868002.7**

(22) Date of filing: **20.08.2024**

(51) International Patent Classification (IPC):
**C30B 29/36** (2006.01)    **C30B 25/02** (2006.01)
**H01L 21/66** (2006.01)

(52) Cooperative Patent Classification (CPC):
**C30B 25/02; C30B 29/36; H10P 74/00**

(86) International application number:
**PCT/JP2024/029509**

(87) International publication number:
**WO 2025/062921 (27.03.2025 Gazette 2025/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.09.2023 JP 2023159185**

(71) Applicant: **Shin-Etsu Handotai Co., Ltd.**
**Tokyo 100-0004 (JP)**

(72) Inventors:
• **MATSUBARA, Toshiki**
  **Nishishirakawa-gun, Fukushima 961-8061 (JP)**
• **OHTSUKI, Tsuyoshi**
  **Nishishirakawa-gun, Fukushima 961-8061 (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

(54) **METHOD FOR EVALUATING CRYSTALLINITY OF 3C-SIC FILM**

(57)    The present invention is a method for evaluating crystallinity of a 3C-SiC film heteroepitaxially grown on a single-crystal silicon substrate, in which crystallinity of the 3C-SiC film of a heteroepitaxial wafer is determined from a stress value for the substrate, which is obtained by employing a WARP value of the heteroepitaxial wafer and Stoney's equation. This provides the method for evaluating crystallinity of the 3C-SiC film heteroepitaxially grown on the single-crystal silicon substrate without requiring any wafer processing operations in a simple and non-destructive manner.

[FIG. 1]

| | |
|---|---|
| S1 | Measuring WARP of Si Substrate |
| S2 | Forming 3C-SiC (Samples for Setting Reference Value) |
| S3 | Measuring WARP |
| S4 | Calculating Stress Value using Stoney's equation |
| S5 | Evaluating Crystallinity of 3C-SiC Film (XRD Measurement) |
| S6 | Setting Reference Stress Value |
| S7 | Measuring WARP of Si Substrate |
| S8 | Forming 3C-SiC (Wafer to be Evaluated), Measuring WARP |
| S9 | Calculating Stress Value using Stoney's equation |
| S10 | Determining Crystallinity of 3C-SiC Film |

EP 4 782 581 A1

## Description

TECHNICAL FIELD

The present invention relates to a method for evaluating crystallinity of a 3C-SiC film.

BACKGROUND ART

SiC has high dielectric breakdown strength by having a wide band gap of 2.2 to 3.3 eV and also has high thermal conductivity. As a result, it is expected to be used for semiconductor materials for various semiconductor devices, such as power devices and high-frequency devices.

Moreover, SiC has been increasingly used for platforms for growing gallium nitride (GaN) (e.g., Patent Document 1). On the other hand, the mainstream of SiC wafers has been those having a small diameter, but larger diameters are desired for power devices and high-frequency devices. Provided that high-quality 3C-SiC single-crystal films can be formed on a large-diameter substrate, it becomes possible to not only utilize the 3C-SiC single-crystal films themselves, but also to produce heteroepitaxial wafers having a large diameter and high-quality GaN layers.

As a method for increasing the diameter of the SiC wafer, the epitaxial growth on a silicon substrate, which provides good compatibility with device processes, has been studied (e.g., Patent Documents 1 and 2).

In order to employ the heteroepitaxial wafers on which 3C-SiC is heteroepitaxially grown on the silicon substrate for the power devices, or the like, 3C-SiC films having excellent crystallinity are required to be grown, and the crystalline states of the heteroepitaxial layers have been determined based on measurements by a transmission electron microscope (TEM: Transmission Electron Microscope) or an X-ray diffraction (XRD: X-Ray Diffraction).

CITATION LIST

PATENT LITERATURE

Patent Document 1: JP 2018-522412 A
Patent Document 2: JP 2021-20819 A

SUMMARY OF INVENTION

TECHNICAL PROBLEM

TEM and XRD are highly suitable for obtaining information regarding a crystalline state in a localized area; however, a problem arises from the need for processing, such as finely dividing a heteroepitaxial wafer into small chips prior to measurement, leading to significant time required for evaluating crystallinity.

The present invention has been made in view of the above-described problem. An object of the present invention is to provide a method for evaluating crystallinity of a 3C-SiC film heteroepitaxially grown on a single-crystal silicon substrate without requiring any wafer processing operations in a simple and non-destructive manner.

SOLUTION TO PROBLEM

To achieve the above object, the present invention provides a method for evaluating crystallinity of a 3C-SiC film heteroepitaxially grown on a single-crystal silicon substrate, the method comprising:

heteroepitaxially growing 3C-SiC under different conditions on a plurality of single-crystal silicon substrates with known WARP values using a reduced-pressure CVD apparatus to provide a plurality of samples for setting a reference value having different degrees of crystallinity of the 3C-SiC film;
measuring WARP values of the plurality of samples for setting the reference value, respectively;
calculating a stress value for the single-crystal silicon substrate of each of the plurality of samples for setting the reference value by substituting the WARP values before and after the heteroepitaxial growth into Stoney's equation;
performing an XRD measurement on the plurality of samples for setting the reference value to evaluate the crystallinity of the 3C-SiC film of each of the plurality of samples for setting the reference value using XRD spectra obtained;
setting a stress value of a sample having the lowest stress value as a reference stress value, among the samples for setting the reference value, which have been determined to exhibit excellent crystallinity in the evaluation of the crystallinity using the XRD spectra;
measuring a WARP value of a heteroepitaxial wafer to be evaluated on which 3C-SiC has been heteroepitaxially grown on a single-crystal silicon substrate having a known WARP value;
calculating a stress value for the single-crystal silicon substrate of the heteroepitaxial wafer to be evaluated by substituting the WARP values before and after the heteroepitaxial growth into Stoney's equation; and
comparing the reference stress value and the stress value of the wafer to be evaluated and determining that the 3C-SiC film of the heteroepitaxial wafer to be evaluated has excellent crystallinity when the stress value of the wafer to be evaluated is equal to the reference stress value or more.

According to such a method for evaluating crystallinity, the crystallinity of the 3C-SiC film heteroepitaxially grown on the single-crystal silicon substrate can be evaluated in a simple and non-destructive manner from the stress value calculated by substituting the WARP value, which is one of the indicators representing a wafer shape, into Stoney's equation.

In this case, in the evaluation of the crystallinity of the samples for setting the reference value using the XRD spectra, the sample in which single-crystal 3C-SiC is grown can be determined to have excellent crystallinity, and the sample in which polycrystalline 3C-SiC is grown can be determined to have poor crystallinity.

Accordingly, the 3C-SiC film heteroepitaxially grown on the single-crystal silicon substrate can be easily evaluated to determine whether the film is single-crystalline or polycrystalline.

ADVANTAGEOUS EFFECTS OF INVENTION

As described above, according to a method for evaluating crystallinity of 3C-SiC according to the present invention, the crystallinity of the 3C-SiC film heteroepitaxially grown on the single-crystal silicon substrate can be evaluated from the stress value calculated by substituting the WARP value, which is one of the indicators representing a wafer shape, into Stoney's equation. Accordingly, the crystallinity can be evaluated without requiring any wafer processing operations in a simple and non-destructive manner.

BRIEF DESCRIPTION OF DRAWINGS

[FIG. 1] is an example of a flowchart for evaluating crystallinity of 3C-SiC according to the present invention.
[FIG. 2] shows stress values, calculated using Stoney's equation, of 3C-SiC heteroepitaxial wafers formed under respective conditions.

DESCRIPTION OF EMBODIMENTS

Hereinafter, the present invention will be described in detail. However, the present invention is not limited thereto.

As described above, a method for evaluating crystallinity of a 3C-SiC film heteroepitaxially grown on a single-crystal silicon substrate without requiring any wafer processing operations in a simple and non-destructive manner has been desired.

To solve the above problem, the present inventors have earnestly studied and found a method for evaluating crystallinity of a 3C-SiC film heteroepitaxially grown on a single-crystal silicon substrate. This method includes: heteroepitaxially growing 3C-SiC under different conditions on a plurality of single-crystal silicon substrates with known WARP values using a reduced-pressure CVD apparatus to provide a plurality of samples for setting a reference value having different degrees of crystallinity of the 3C-SiC film; measuring WARP values of the plurality of samples for setting the reference value, respectively; calculating a stress value for the single-crystal silicon substrate of each of the plurality of samples for setting the reference value by substituting the WARP values before and after the heteroepitaxial growth into Stoney's equation; performing an XRD measurement on the plurality of samples for setting the reference value to evaluate the crystallinity of the 3C-SiC film of each of the plurality of samples for setting the reference value using XRD spectra obtained; setting a stress value of a sample having the lowest stress value as a reference stress value, among the samples for setting the reference value, which have been determined to exhibit excellent crystallinity in the evaluation of the crystallinity using the XRD spectra; measuring a WARP value of a heteroepitaxial wafer to be evaluated on which 3C-SiC has been heteroepitaxially grown on a single-crystal silicon substrate having a known WARP value; calculating a stress value for the single-crystal silicon substrate of the heteroepitaxial wafer to be evaluated by substituting the WARP values before and after the heteroepitaxial growth into Stoney's equation; and comparing the reference stress value and the stress value of the wafer to be evaluated and determining that the 3C-SiC film of the heteroepitaxial wafer to be evaluated has excellent crystallinity when the stress value of the wafer to be evaluated is equal to the reference stress value or more. The present inventors found that this method enables the evaluation of the crystallinity of the 3C-SiC film heteroepitaxially grown on the single-crystal silicon substrate in a simple and non-destructive manner from the stress value calculated by substituting the WARP value, which is one of the indicators representing a wafer shape, into the Stoney's equation. Based on this finding, the present invention has been completed.

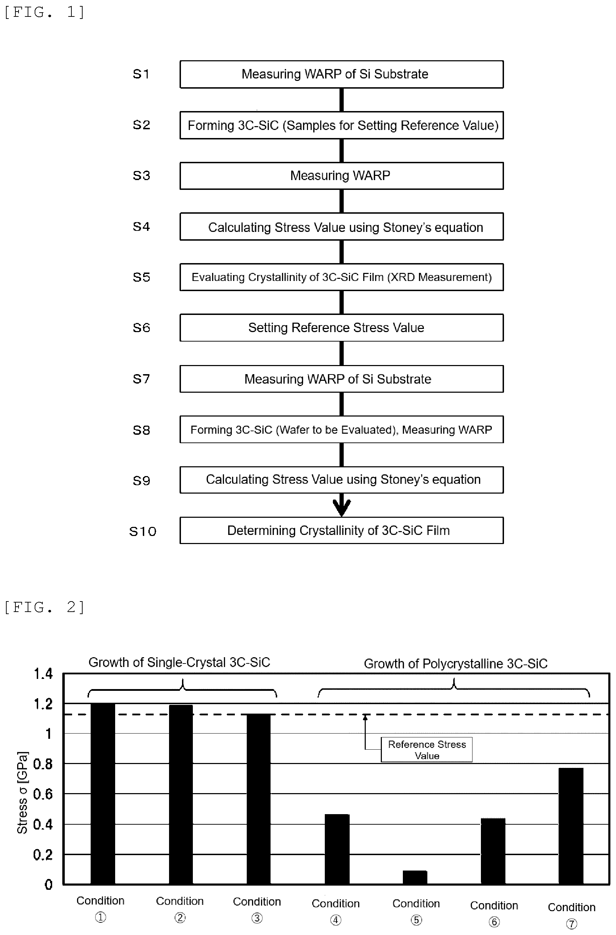

Hereinafter, a method for evaluating crystallinity of a 3C-SiC film according to the embodiment of the present invention will be described with reference to FIG. 1. FIG. 1 is an example of a flowchart of the method for evaluating crystallinity of the 3C-SiC film according to the present invention.

[Setting Reference Stress Value]

First, as shown in S1 of FIG. 1, the plurality of single-crystal silicon substrates is provided, and the WARP values thereof are measured, respectively. Note that the provided single-crystal silicon substrates preferably comply with the same standards as those applied to the single-crystal silicon substrates to be evaluated.

Next, as shown in S2 of FIG. 1, the single-crystal silicon substrates having the known WARP values are placed in the reduced-pressure (RP)-CVD apparatus, and 3C-SiC is heteroepitaxially grown under various forming conditions, thereby providing the plurality of samples for setting the reference value having the different crystallinities of the 3C-SiC films. Si and 3C-SiC have a difference in lattice constant therebetween of about 20%, and thus, when 3C-SiC is formed on the silicon substrate, tensile stress is applied thereto, thereby causing the substrate to warp into a downwardly convex shape.

Next, as shown in S3 of FIG. 1, a shape measurement is performed on each of the obtained samples for setting the reference value, and WARP, as the indicator representing the warp amount, is measured.

Subsequently, as shown in S4 of FIG. 1, the WARP values before and after the heteroepitaxial growth are substituted into Stoney's equation shown below, which can calculate the stress from the warp of the substrate, thereby calculating the stress value for the single-crystal silicon substrate of each of the samples for setting the reference value.

[Math. 1]

$$\sigma_f = \frac{E_s t_s^2}{(1-v)6t_f}\left(\frac{1}{R_1} - \frac{1}{R_0}\right)$$

where,

$\sigma_f$ represents stress,
E represents modulus of elasticity (Young's modulus),
t represents thickness,
$v$ represents Poisson's ratio,
$R_1$ represents a curvature radius of a wafer after film formation,
$R_0$ represents a curvature radius of a wafer before film formation.
($_f$ represents 3C-SiC film, $_s$ represents substrate).

Meanwhile, the curvature radius R is expressed by the following equation.

[Math. 2]

$$R = \frac{r^2}{2d}$$

where,

r represents a substrate radius,
d represents the amount of warp (WARP).

When 3C-SiC having low crystallinity is grown, lattice relaxation is induced by a large number of misfit dislocations generated in the film, thereby decreasing the WARP value and lowering the stress value calculated from the Stoney's equation. Conversely, when 3C-SiC having high crystallinity is grown, the number of dislocation defects in the film is reduced, making the lattice relaxation less prone to being generated. As a result, the WARP value is increased, and the stress value calculated from the Stoney's equation becomes higher.

Moreover, as shown in S5 of FIG. 1, XRD measurements are performed on the samples for setting the reference value, and the crystallinity of the 3C-SiC films of each of the samples for setting the reference value is evaluated by using the XRD spectra obtained.

Next, as shown in S6 of FIG. 1, a stress value of a sample having the lowest stress value, among the samples for setting the reference value, which has been determined to exhibit excellent crystallinity in the evaluation of the crystallinity using the XRD spectra, is set as a reference stress value.

The description is provided using a concrete example. FIG. 2 shows a relation between the degrees of crystallinity and the stress values of the wafer, obtained by growing 3C-SiC under different growth conditions on 7 single-crystal silicon substrates in which WARP values thereof have been measured in advance as the samples for setting the reference value, and by measuring the WARP values, and then by calculating the stress values, and then by investigating the degrees of crystallinity. As shown in FIG. 2, regarding 3C-SiC formed under the conditions 1 to 3, the growth of single-crystal 3C-SiC is confirmed from XRD spectra, and the crystallinity is determined to be excellent. Conversely, regarding 3C-SiC formed under the conditions 4 to 7, the growth of the polycrystalline 3C-SiC is confirmed from XRD spectra, and the crystallinity is determined to be poor. From these results, the stress value under the condition 3 (1.13 GPa) can be set as the reference stress value.

In the above evaluation of the crystallinity of the samples for setting the reference value using XRD spectra, the sample in which single-crystal 3C-SiC has been grown can be determined to have excellent crystallinity, and the sample in which polycrystalline 3C-SiC has been grown can be determined to have poor crystallinity. Accordingly, it can be easily evaluated whether the 3C-SiC film heteroepitaxially grown on the single-crystal silicon substrate is single-crystalline or polycrystalline.

[Evaluating Crystallinity of 3C-SiC Film to be Evaluated]

Next, the method for evaluating crystallinity of a 3C-SiC film heteroepitaxially grown on the single-crystal silicon substrate to be evaluated, using the reference stress value obtained by the method described earlier, will be described.

First, as shown in S7 of FIG. 1, a WARP value of a single-crystal silicon substrate on which 3C-SiC to be evaluated is to be heteroepitaxially grown is measured in advance.

Next, as shown in S8 of FIG. 1, the single-crystal silicon substrate having the known WARP value is placed in a reduced-pressure (RP)-CVD apparatus, 3C-SiC is heteroepitaxially grown, and a WARP value of the resulting wafer is then measured.

Subsequently, as shown in S9 of FIG. 1, the WARP values before and after heteroepitaxial growth are substituted into the Stoney's equation, and a stress value for the single-crystal silicon substrate of the wafer to be evaluated is calculated.

Finally, as shown in S10 of FIG. 1, the reference stress value is compared with the stress value of the wafer to be evaluated, and when the stress value of the wafer to be evaluated is equal to the reference stress value or more, it is determined that the 3C-SiC film of the wafer to be evaluated has excellent crystallinity.

In the example of FIG. 2, the stress value under the condition 3 is set as the reference stress value; accordingly, when a stress value of an actual wafer to be evaluated is 1.13 GPa, which is the reference stress value, or more, the crystallinity of the 3C-SiC film is determined to be excellent; when it is less than the reference stress value, the crystallinity of the 3C-SiC film is determined to be poor.

By employing the inventive evaluation method, the crystallinity of the 3C-SiC film heteroepitaxially grown on the single-crystal silicon substrate can be evaluated from the stress value calculated by substituting the WARP value, which is one of the indicators representing a wafer shape, into the Stoney's equation. Accordingly, the crystallinity can be evaluated in a simple and non-destructive manner.

Note that, when the inventive method for evaluation is applied, the formation of 3C-SiC on the silicon substrate applies the tensile stress to the silicon substrate as described above, and this generates a downward convex shape warp on the substrate. Consequently, this method is preferably applied to the wafer on which 3C-SiC is heteroepitaxially grown on the single-crystal silicon substrate that has a warp in an upward convex shape.

EXAMPLES

Hereinafter, the present invention will be specifically described with reference to Example. However, the present invention is not limited thereto.

(Example)

Seven single-crystal silicon substrates, for which WARP values had been measured, were provided. The provided single-crystal silicon substrates had a diameter of 300 mm, a plane orientation of (111), a resistivity of 10 $\Omega$·cm, and were of p-type. Each single-crystal silicon substrate having the measured WARP values was placed on a susceptor in a reaction furnace of a reduced-pressure CVD apparatus, and 3C-SiC was then heteroepitaxially grown under 7 different forming conditions.

The WARP values of 7 types of the obtained wafers were measured, and the WARP values before and after the formation were substituted into Stoney's equation, thereby calculating respective stress values for the wafers.

When the obtained 3C-SiC films were further subjected to an XRD measurement under in-plane diffraction conditions, only peaks derived from a (220) plane were detected from XRD spectra of 3C-SiC formed under the conditions 1 to 3; accordingly, it was confirmed that single-crystal 3C-SiC was grown, and it was determined that the 3C-SiC films had excellent crystallinity. Alternatively, for 3C-SiC formed under the conditions 4 to 7, in addition to the peaks derived from the (220) plane, the peaks derived from a (111) and a (311) plane were detected from the XRD spectra, confirming that polycrystalline 3C-SiC was grown, and the crystallinity of the 3C-SiC films was determined to be poor (hereinafter, also referred to as excellent/poor in XRD evaluation).

Among the stress values of the wafers under respective conditions 1 to 3, in which the XRD evaluations were excellent, the lowest stress value was the stress value under the condition 3 (1.13 GPa), and this stress value was set as a reference stress value.

FIG. 2 shows the stress values of 3C-SiC heteroepitaxial wafers formed under respective conditions. As shown in FIG. 2, in the wafers under conditions 1 and 2, for which the XRD evaluations were excellent, the stress of the reference stress value or more was applied to the substrates. In contrast, in the wafers under conditions 4 to 7, for which the XRD evaluations were poor, the stress applied to the substrates was less than the reference stress value.

Next, the evaluation of an actual 3C-SiC film to be evaluated was performed. A single-crystal silicon substrate used had a diameter of 300 mm, a plane orientation of (111), a resistivity of 10 $\Omega$·cm, and was of p-type. First, when a WARP value of the single-crystal silicon substrate on which a 3C-SiC film was to be heteroepitaxially grown was measured, the WARP value was 4.36 $\mu$m. The 3C-SiC film was then heteroepitaxially grown on the single-crystal silicon substrate, and a WARP value of the resulting heteroepitaxial wafer was measured. This WARP value was 19.97 $\mu$m. Next, the WARP values before and after the heteroepitaxial growth were substituted into Stoney's equation, and a stress value for the single-crystal silicon substrate of the produced heteroepitaxial wafer was calculated, resulting in the value of 1.19 GPa. This value is, as can be determined from FIG. 2, equal to or more than the reference stress value defined from the stress value under the condition 3 (1.13 GPa). Then, it was determined that the 3C-SiC film had excellent crystallinity.

The produced heteroepitaxial wafer was actually subjected to the XRD measurement to confirm the spectrum, and then, it was confirmed that the single-crystal 3C-SiC film was obtained.

As described above, according to Example of the present invention, it was confirmed that the crystallinity of 3C-SiC can be determined from the stress applied to the substrates on which the 3C-SiC heteroepitaxial films were formed under different conditions.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

**Claims**

1. A method for evaluating crystallinity of a 3C-SiC film heteroepitaxially grown on a single-crystal silicon substrate, the method comprising:

    heteroepitaxially growing 3C-SiC under different conditions on a plurality of single-crystal silicon substrates with known WARP values using a reduced-pressure CVD apparatus to provide a plurality of samples for setting a reference value having different degrees of crystallinity of the 3C-SiC film;
    measuring WARP values of the plurality of samples for setting the reference value, respectively;
    calculating a stress value for the single-crystal silicon substrate of each of the plurality of samples for setting the reference value by substituting the WARP values before and after the heteroepitaxial growth into Stoney's equation;
    performing an XRD measurement on the plurality of samples for setting the reference value to evaluate the crystallinity of the 3C-SiC film of each of the plurality of samples for setting the reference value using XRD spectra obtained;
    setting a stress value of a sample having the lowest stress value as a reference stress value, among the samples for setting the reference value, which have been determined to exhibit excellent crystallinity in the evaluation of the crystallinity using the XRD spectra;
    measuring a WARP value of a heteroepitaxial wafer to be evaluated on which 3C-SiC has been heteroepitaxially grown on a single-crystal silicon substrate having a known WARP value;
    calculating a stress value for the single-crystal silicon substrate of the heteroepitaxial wafer to be evaluated by substituting the WARP values before and after the heteroepitaxial growth into Stoney's equation; and
    comparing the reference stress value and the stress value of the wafer to be evaluated and determining that the 3C-SiC film of the heteroepitaxial wafer to be evaluated has excellent crystallinity when the stress value of the wafer to be evaluated is equal to the reference stress value or more.

2. The method for evaluating crystallinity of a 3C-SiC film according to claim 1, wherein
in the evaluation of the crystallinity of the samples for setting the reference value using the XRD spectra, the sample in which single-crystal 3C-SiC is grown is determined to have excellent crystallinity, and the sample in which polycrystalline 3C-SiC is grown is determined to have poor crystallinity.

[FIG. 1]

| | |
|---|---|
| S1 | Measuring WARP of Si Substrate |
| S2 | Forming 3C-SiC (Samples for Setting Reference Value) |
| S3 | Measuring WARP |
| S4 | Calculating Stress Value using Stoney's equation |
| S5 | Evaluating Crystallinity of 3C-SiC Film (XRD Measurement) |
| S6 | Setting Reference Stress Value |
| S7 | Measuring WARP of Si Substrate |
| S8 | Forming 3C-SiC (Wafer to be Evaluated), Measuring WARP |
| S9 | Calculating Stress Value using Stoney's equation |
| S10 | Determining Crystallinity of 3C-SiC Film |

[FIG. 2]

## INTERNATIONAL SEARCH REPORT

| International application No. |
| --- |
| **PCT/JP2024/029509** |

| A. | CLASSIFICATION OF SUBJECT MATTER |
| --- | --- |

*C30B 29/36*(2006.01)i; *C30B 25/02*(2006.01)i; *H01L 21/66*(2006.01)i
FI:   C30B29/36 A; C30B25/02 Z; H01L21/66 N

According to International Patent Classification (IPC) or to both national classification and IPC

| B. | FIELDS SEARCHED |
| --- | --- |

Minimum documentation searched (classification system followed by classification symbols)

C30B29/36; C30B25/02; H01L21/66;G01R31/26

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2011-066360 A (COVALENT MATERIALS CORP.) 31 March 2011 (2011-03-31) | 1-2 |
| A | JP 2007-080916 A (SEIKO EPSON CORPORATION) 29 March 2007 (2007-03-29) | 1-2 |
| A | JP 2000-012900 A (SUMITOMO ELECTRIC INDUSTRIES, LTD.) 14 January 2000 (2000-01-14) | 1-2 |

☐ Further documents are listed in the continuation of Box C.      ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **27 September 2024** | **08 October 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
**Information on patent family members**

International application No.

**PCT/JP2024/029509**

| Patent document cited in search report | | | Publication date (day/month/year) | Patent family member(s) | | | Publication date (day/month/year) |
|---|---|---|---|---|---|---|---|
| JP | 2011-066360 | A | 31 March 2011 | (Family: none) | | | |
| JP | 2007-080916 | A | 29 March 2007 | (Family: none) | | | |
| JP | 2000-012900 | A | 14 January 2000 | US | 6413627 | B1 | |
| | | | | EP | 0966047 | A2 | |
| | | | | CN | 1196176 | C | |
| | | | | KR | 2000-0006299 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018522412 A

- JP 2021020819 A